# EUROPÄISCHE PATENTSCHRIFT

(11) **EP 1 978 600 B1**
(45) Veröffentlichungstag und Bekanntmachung des Hinweises auf die Patenterteilung: **29.04.2009**
(21) Anmeldenummer: 07003677.7
(22) Anmeldetag: 22.02.2007
(51) Int. Cl.: H01R 12/04

(54) **Platinenanordnung**
Board assembly
Agencement de platine

(43) Veröffentlichungstag der Anmeldung: 08.10.2008
(73) Patentinhaber: Delphi Technologies, Inc., Troy, Michigan 48007 (US)
(72) Erfinder: Hombach, Frank, 51674 Wiehl (DE); Hupertz, Stefan, 57462 Olpe (DE); Noll, Diethelm, 57589 Birkenbeul (DE)
(74) Vertreter: Denton, Michael John

(56) Entgegenhaltungen:
- FR-A1- 2 693 340
- US-A- 5 336 095

## Beschreibung

Die Erfindung betrifft eine Vorrichtung, insbesondere für ein elektrisches Verteilungssystem für ein Kraftfahrzeug, mit wenigstens zwei Platinen und/oder Sicherungshaltern und mit einem oder mehreren Steckverbindern zum Herstellen einer elektrischen Verbindung zu einem Kabelbaum.

Platinen, auf denen Steckverbinder und/oder Sicherungshalter angebracht sind, kommen beispielsweise in einer Stromverteilerbox oder BCU (Body Controller Unit) in Kraftfahrzeugen zum Einsatz. Mehrere Platinen sind dabei über mechanische Verbindungen aneinander befestigt. Allerdings ist das Bestücken der Platinen mit Steckverbindern und/oder Sicherungshaltern und das mechanische Verbinden der Platinen miteinander zeitaufwendig und kostenintensiv.

FR 2 693 340 A1 beschreibt eine Anordnung aus zwei Platinen, die durch wenigstens ein Verbindungsstück miteinander verbunden sind, das metallisch und L-förmig ausgebildet ist. Das Verbindungsstück ist an seinen Enden mit Klemmabschnitten versehen, um eine elektrische und mechanische Verbindung zwischen den beiden Platinen herzustellen. EP 1 487 247 A1 beschreibt einen Steckverbinder, dessen elektrische Anschlüsse mit Leiterplatten verbunden sind.

Der Erfindung liegt die Aufgabe zugrunde, eine Vorrichtung der eingangs genannten Art anzugeben, welche schneller und/oder kostengünstiger fertigbar ist.

Diese Aufgabe wird durch eine Vorrichtung mit den Merkmalen des Anspruchs 1 gelöst.

Erfindungsgemäß sorgen das eine Steckverbindergehäuse eine Sicherungshaltergehäuse oder die mehreren Steckverbindergehäuse und/oder Sicherungshaltergehäuse für die mechanische Verbindung der Platinen miteinander. Dies ermöglicht, dass auf separate mechanische Verbindungsmittel, welche lediglich zu diesem Zweck vorgesehen sind, verzichtet werden kann. Hierdurch kann die Vorrichtung sowohl schneller als auch kostengünstiger gefertigt werden.

Der oder die mehreren Steckverbinder und/oder Sicherungshalter erfüllen dabei eine Doppelfunktion. Zum einen sind sie für die mechanische Befestigung der Platinen aneinander zuständig. Zum anderen sind sie gleichzeitig auch elektrisch wirksam, d.h. der Steckverbinder kann zusätzlich seine eigentliche Funktion als Steckverbinder erfüllen und eine elektrische Verbindung zu einem Kabelbaum herstellen, und der Sicherungshalter kann zusätzlich seine eigentliche Funktion als Sicherungshalter erfüllen und eine oder mehrere elektrische Sicherungen aufnehmen.

Bei den mehreren Steckverbindern und/oder Sicherungshaltern kann es sich um ausschließlich Steckverbinder, ausschließlich Sicherungshalter oder eine Kombination aus wenigstens einem Steckverbinder und wenigstens einem Sicherungshalter handeln. Zwei Platinen können jeweils durch eines oder aber auch durch wenigstens zwei der mehreren Steckverbindergehäuse und/oder Sicherungshaltergehäuse aneinander befestigt sein. Eine Platine kann unmittelbar oder lediglich mittelbar über eine benachbarte Platine an einer anderen Platine befestigt sein. Es ist auch möglich, dass das oder zumindest eines der mehreren Steckverbindergehäuse und/oder Sicherungshaltergehäuse jeweils drei oder mehr Platinen aneinander befestigt.

Neben dem oder den mehreren Steckverbindergehäusen und/oder Sicherungshaltergehäusen, welche zur Befestigung der Platinen aneinander vorgesehen sind, können ein oder mehrere weitere Steckverbinder und/oder Sicherungshalter vorgesehen sein, die in herkömmlicher Weise auf den Platinen angeordnet sind und nicht zur Bereitstellung einer mechanischen Verbindung verwendet werden.

Bevorzugt sind die Platinen ausschließlich durch das oder die mehreren Steckverbindergehäuse und/oder Sicherungshaltergehäuse aneinander befestigt. Hierdurch wird eine besonders schnelle und kostengünstige Herstellung gewährleistet.

Nach einer Ausgestaltung der Erfindung sind die Platinen nebeneinander angeordnet. Grundsätzlich ist es jedoch auch möglich, dass die Platinen übereinander angeordnet sind und das oder die mehreren Steckverbindergehäuse und/ oder Sicherungshaltergehäuse eine seitliche mechanische Befestigung bereitstellen. Darüber hinaus ist auch eine Anordnung aus zumindest drei Platinen möglich, bei der wenigstens zwei Platinen nebeneinander und wenigstens zwei Platinen übereinander angeordnet sind.

Nach einer anderen Ausgestaltung der Erfindung ist der oder zumindest einer der mehreren Steckverbinder und/oder Sicherungshalter jeweils mit wenigstens zwei der Platinen, welche durch die jeweiligen Steckverbindergehäuse oder Sicherungshaltergehäuse aneinander befestigt sind, zusätzlich elektrisch verbunden. Grundsätzlich ist es jedoch auch möglich, dass der jeweilige Steckverbinder oder Sicherungshalter zwar mit zwei oder mehreren Platinen mechanisch verbunden, jedoch nur mit einer und/oder nicht mit allen der mehreren Platinen elektrisch verbunden ist.

Nach einer anderen Ausgestaltung der Erfindung stellt der oder zumindest einer der mehreren Steckverbinder und/oder Sicherungshalter jeweils eine elektrische Verbindung, insbesondere Drahtverbindung, zwischen den durch das jeweilige Steckverbindergehäuse oder Sicherungshaltergehäuse aneinander befestigten Platinen bereit. Hierdurch können Energie und/ oder Signale zwischen den mechanisch miteinander verbundenen Platinen ausgetauscht werden.

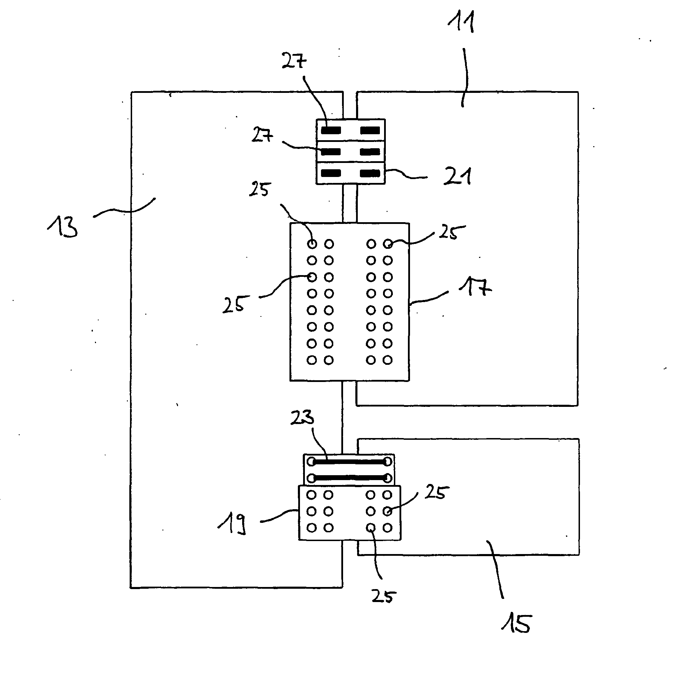

Nicht beschränkende Ausführungsbeispiele der Erfindung sind in der Zeichnung dargestellt und werden nachfolgend beschrieben.

Die Figur zeigt, in schematischer Darstellung, eine erfindungsgemäße Vorrichtung.

Die erfindungsgemäße Vorrichtung umfasst drei nebeneinander angeordnete starre Platinen 11, 13 und 15, welche auch als Leiterplatten oder PCBs (Printed Circuit Boards) bezeichnet werden, und welche mit passiven Bauelementen und/oder integrierten Schaltkreisen bestückt sind. Beispielsweise kann es sich bei Platine 13 um eine Platine für Leistungselektronik und bei den Platinen 11 und 15 um Platinen für Signalelektronik handeln.

Die erfindungsgemäße Vorrichtung umfasst ferner einen Steckverbinder 17, der die beiden Platinen 11 und 13 mechanisch miteinander verbindet, einen Steckverbinder 19, der die beiden Platinen 13 und 15 mechanisch miteinander verbindet, und einen Sicherungshalter 21, der ebenfalls die beiden Platinen 11 und 13 mechanisch miteinander verbindet.

Die Befestigung der Steckverbinder 17, 19 bzw. des Sicherungshalters 21 an den Platinen 11, 13 und 15 kann beispielsweise durch Kleben, eine Steckverbindung und/oder mechanische Befestigungsmittel wie Schrauben erreicht werden. Die Steckverbinder 17, 19 und der Sicherungshalter 21, welche jeweils ein Gehäuse aufweisen, beispielsweise aus Kunststoff, überlappen hierzu jeweils mit den beiden jeweils zugeordneten Platinen 11, 13, 15.

Die beiden Steckverbinder 17, 19 sind jeweils als Stecker ausgebildet, wie anhand der Vielzahl von Kontaktstiften 25 erkennbar ist. Beispielsweise können die beiden linken Reihen der Kontaktstifte 25 des Steckverbinders 17 mit der Platine 13 und die beiden rechten Reihen der Kontaktstifte 25 des Steckverbinders 17 mit der Platine 11 elektrisch verbunden sein.

Der Sicherungshalter 21 ist als Buchse ausgebildet und kann in der in der Figur gezeigten Ausführungsform drei Flachsteck-Sicherungen aufnehmen, wie anhand der Kontaktbuchsen 27 erkennbar ist.

Der Steckverbinder 19 umfasst neben den Kontaktstiften 25 zusätzlich eine Drahtverbindung 23, welche zwei parallel zueinander verlaufende Drähte umfasst, um eine elektrische Verbindung zwischen den beiden Platinen 13 und 15 bereitzustellen, so dass über den Steckverbinder 19 ein Austausch von Energie und/oder Signalen zwischen den Platinen 13 und 15 ermöglicht ist.

### Bezugszeichenliste:

- 11: Platine
- 13: Platine
- 15: Platine
- 17: Steckverbinder
- 19: Steckverbinder
- 21: Sicherungshalter
- 23: Drahtverbindung
- 25: Kontaktstift
- 27: Kontaktbuchse

## Patentansprüche

1. Vorrichtung, insbesondere für ein elektrisches Verteilungssystem für ein Kraftfahrzeug, mit wenigstens zwei Platinen (11, 13, 15) und mit einem oder mehreren Sicherungshaltern (21) und/oder zum Herstellen einer elektrischen Verbindung zu einem Kabelbaum vorgesehenen Steckverbindern (17, 19),
**dadurch gekennzeichnet,**
**dass** ein oder mehrere Steckverbindergehäuse (17, 19) und/oder Sicherungshaltergehäuse (21) jeweils wenigstens zwei der Platinen (11, 13, 15) überlappen und mittels mechanischer Verbindungsmittel mechanisch aneinander befestigen, wobei zusätzlich elektrische Verbindungsmittel vorgesehen sind, mit denen der oder zumindest einer der mehreren Steckverbinder (17, 19) und/oder Sicherungshalter (21) mit wenigstens einer der Platinen (11, 13, 15), die durch das jeweilige Steckverbindergehäuse (17, 19) oder Sicherungshaltergehäuse (21) an einer anderen Platine befestigt sind, elektrisch verbunden ist.

2. Vorrichtung nach Anspruch 1,
**dadurch gekennzeichnet,**
**dass** die Platinen (11, 13, 15) ausschließlich durch das oder die mehreren Steckverbindergehäuse (17, 19) und/oder Sicherungshaltergehäuse (21) aneinander befestigt sind.

3. Vorrichtung nach Anspruch 1 oder 2,
**dadurch gekennzeichnet,**
**dass** die Platinen (11, 13, 15) nebeneinander angeordnet sind.

4. Vorrichtung nach zumindest einem der vorstehenden Ansprüche,
**dadurch gekennzeichnet,**
**dass** der oder zumindest einer der mehreren Steckverbinder (19) und/oder Sicherungshalter jeweils eine elektrische Verbindung (23), insbesondere Drahtverbindung, zwischen den durch die jeweiligen Steckverbindergehäuse (19) oder Sicherungshaltergehäuse aneinander befestigten Platinen (13, 15) bereitstellt.

## Claims

1. Device, in particular for an electrical distribution system for a motor vehicle, having at least two plates (11, 13, 15) and having one or more fuse holders (21) and/or plug-in connectors (17, 19) provided for making an electrical connection to a cable harness, **characterised in that** one or more plug-in connector housings (17, 19) and/or fuse holder housings (21) in each case overlap at least two of the plates (11, 13, 15) and fasten them to each other mechanically by mechanical connecting means, electrical connecting means being provided in addition, with which the or at least one of the several plug-in connectors (17, 19) and/or fuse holders (21) is electrically connected to at least one of the plates (11, 13, 15) which are fastened to another plate by the respective plug-in connector housing (17, 19) or fuse holder housing (21).

2. Device according to claim 1, **characterised in that** the plates (11, 13, 15) are fastened to each other exclusively by the plug-in connector housing or housings (17, 19) and/or fuse holder housing or housings (21).

3. Device according to claim 1 or 2, **characterised in that** the plates (11, 13, 15) are arranged adjacent to each other.

4. Device according to one or more of the preceding claims, **characterised in that** the or at least one of the several plug-in connectors (17, 19) and/or fuse holders in each case provides an electrical connection (23), in particular wire connection, between the plates (13, 15) fastened to each other by the respective plug-in connector housings (19) or fuse holder housings.

## Revendications

1. Dispositif destiné en particulier à un système électrique de distribution pour un véhicule automobile, comportant au moins deux platines (11, 13, 15) et un ou plusieurs porte-fusible(s) (21) et/ou des connecteurs à fiche (17, 19) prévus pour établir une connexion électrique vers un faisceau de câbles,
**caractérisé en ce que**
un ou plusieurs boîtier(s) de connecteur à fiche (17, 19) et/ou un ou plusieurs boîtier(s) de porte-fusible (21) chevauchent chacun au moins deux des platines (11, 13, 15) et les fixent mécaniquement l'une sur l'autre au moyen d'organes de liaison mécaniques, des organes de connexion électriques étant prévus en supplément au moyen desquels le ou un au moins des plusieurs connecteur(s) à fiche (17, 19) et/ou des porte-fusible(s) (21) est connecté électriquement à l'une au moins des platines (11, 13, 15) qui sont fixées sur une autre platine par le boîtier de connecteur à fiche respectif (17, 19) ou par le boîtier de porte-fusible respectif (21).

2. Dispositif selon la revendication 1,
**caractérisé en ce que**
les platines (11, 13, 15) sont fixées les unes sur les autres exclusivement par le ou les plusieurs boîtier(s) de connecteur à fiche (17, 19) et/ou boîtier(s) de porte-fusible (21).

3. Dispositif selon la revendication 1 ou 2,
**caractérisé en ce que**
les platines (11, 13, 15) sont agencées les unes à côté des autres.

4. Dispositif selon l'une au moins des revendications précédentes,
**caractérisé en ce que**
le ou l'un au moins des plusieurs connecteur(s) à fiche (19) et/ou porte-fusible(s) fournit une connexion électrique respective (23), en particulier une connexion par fil, entre les platines (13, 15) fixées l'une sur l'autre par le boîtier de connecteur à fiche respectif (19) ou par le boîtier de porte-fusible respectif.
